# EUROPÄISCHE PATENTSCHRIFT

(11) **EP 0 961 286 B1**
(45) Veröffentlichungstag und Bekanntmachung des Hinweises auf die Patenterteilung: **16.04.2003**
(21) Anmeldenummer: 99109759.3
(22) Anmeldetag: 18.05.1999
(51) Int. Cl.: G11C 8/00, G11C 11/408

(54) **Anordnung zur Übersprechdämpfung in Wortleitungen von Dram-Schaltungen**
DRAM word line crosstalk reduction
Réduction de diaphonie entre lignes de mot de mémoires DRAM

(30) Priorität: 28.05.1998 DE 19823956
(43) Veröffentlichungstag der Anmeldung: 01.12.1999
(73) Patentinhaber: Infineon Technologies AG, 80506 München (DE)
(72) Erfinder: Brox, Martin, Dr., 81825 München (DE); Scheinder, Helmut, 80993 München (DE); Vogelsang,Thomas, Dr., Williston, 05495 Vermont (US); Killian, Mike, Richmont, 05477 Vermont (US)
(74) Vertreter: Müller - Hoffmann & Partner

(56) Entgegenhaltungen:
- US-A- 4 602 355
- US-A- 4 764 902
- US-A- 5 161 121
- US-A- 5 282 167

## Beschreibung

Die vorliegende Erfindung betrifft eine Anordnung zur Übersprechdämpfung in im wesentlichen parallel zueinander verlaufenden Wortleitungen von DRAM-Schaltungen nach dem Oberbegriff des Patentanspruches.

In parallel zueinander verlaufenden Wortleitungen von integrierten DRAM-Schaltungen tritt ein Übersprechen zwischen benachbarten Wortleitungen auf, das sich umso störender auswirkt, je enger die Wortleitungen beieinanderliegen und je länger diese sind. Dieses Übersprechen ist auf eine kapazitive Kopplung zwischen den sich wie lange RC-Leitungen verhaltenden Wortleitungen zurückzuführen.

Um ein derartiges Übersprechen zu verhindern, wurde bisher daran gedacht, die Länge der verwendeten Wortleitungen so zu beschränken, daß durch Übersprechen erzeugte Spannungen einen kritischen Wert nicht übersteigen.

Die Beschränkung der Länge der verwendeten Wortleitungen steht aber in Widerspruch zu dem Ziel, DRAM-Schaltungen mit möglichst vielen Speicherzellen zu versehen.

Aus der US-A-5,282,167 ist eine Anordnung zur Übersprechdämpfung von parallel zueinander verlaufenden Wortleitungen bekannt, bei der eine Pull-Down-Einrichtung aus einem mit der Wortleitung verbundenen N-Kanal-MOS-Transistor besteht. Außerdem ist ein Inverter vorhanden, dessen Ausgang an das Gate des N-Kanal-MOS-Transistors angeschlossen ist.

Weiterhin ist in der US-A-5,161,121 eine Anordnung zur Übersprechdämpfung von parallel zueinander verlaufenden Wortleitungen beschrieben, bei der ein Dekoder an einem Ende der Wortleitung und eine Pull-Down-Einrichtung am anderen Ende der Wortleitung vorgesehen sind. Der Oberbegriff des Anspruchs geht auf diese Veröffentlichung zurück.

Es ist Aufgabe der vorliegenden Erfindung, eine Anordnung zur Übersprechdämpfung in im wesentlichen parallel zueinander verlaufenden Wortleitungen von DRAM-Schaltungen zu schaffen, mit der ohne Beschränkung der Länge der Wortleitungen ein Übersprechen zwischen benachbarten Wortleitungen zuverlässig vermieden werden kann, wobei gleichzeitig eine Segmentselektion von Wortleitungen möglich sein soll.

Diese Aufgabe wird bei einer Anordnung der eingangs genannten Art erfindungsgemäß durch die im kennzeichnenden Teil des Patentanspruches angegebenen Merkmale gelöst.

Bei der erfindungsgemäßen Anordnung ist also an einem Ende jeder Wortleitung eine Pull-Down-Einrichtung vorgesehen, die sich als "Noise-Killer" (Rausch-Killer) verhält und dafür sorgt, daß das Potential einer nicht aktivierten Wortleitung immer dann heruntergezogen wird, wenn durch Übersprechen von einer benachbarten, aktivierten Wortleitung ein Potentialanstieg zu beobachten ist.

Für die Pull-Down-Einrichtung wird dabei ein N-Kanal-MOS-Transistor verwendet, der durch ein Array-Steuersignal ansteuerbar ist. Die Anordnung weist so zwei N-Kanal-MOS-Transistoren auf, nämlich den N-Kanal-MOS-Transistor für den Haltetransistor und den N-Kanal-MOS-Transistor für die Pull-Down-Einrichtung.

Die erfindungsgemäße Anordnung mit zwei N-Kanal-MOS-Transistoren ist besonders vorteilhaft, da sie ein schnelles Abschalten der Wortleitung von beiden Seiten aus ermöglicht, indem hier eine doppelseitige Dämpfung an den einer aktiven Wortleitung benachbarten Wortleitungen auftritt. Durch das Array-Steuersignal kann außerdem eine Segmentselektion vorgenommen werden.

Nachfolgend wird die Erfindung anhand der Zeichnungen näher erläutert. Es zeigen:
- Fig. 1 und 2: zwei verschiedene Anordnungen zur Übersprechdämpfung,
- Fig. 3: ein Ausführungsbeispiel der erfindungsgemäßen Anordnung und
- Fig. 4: ein schematisches Diagramm zur weiteren Erläuterung des Ausführungsbeispiels der Fig. 3.

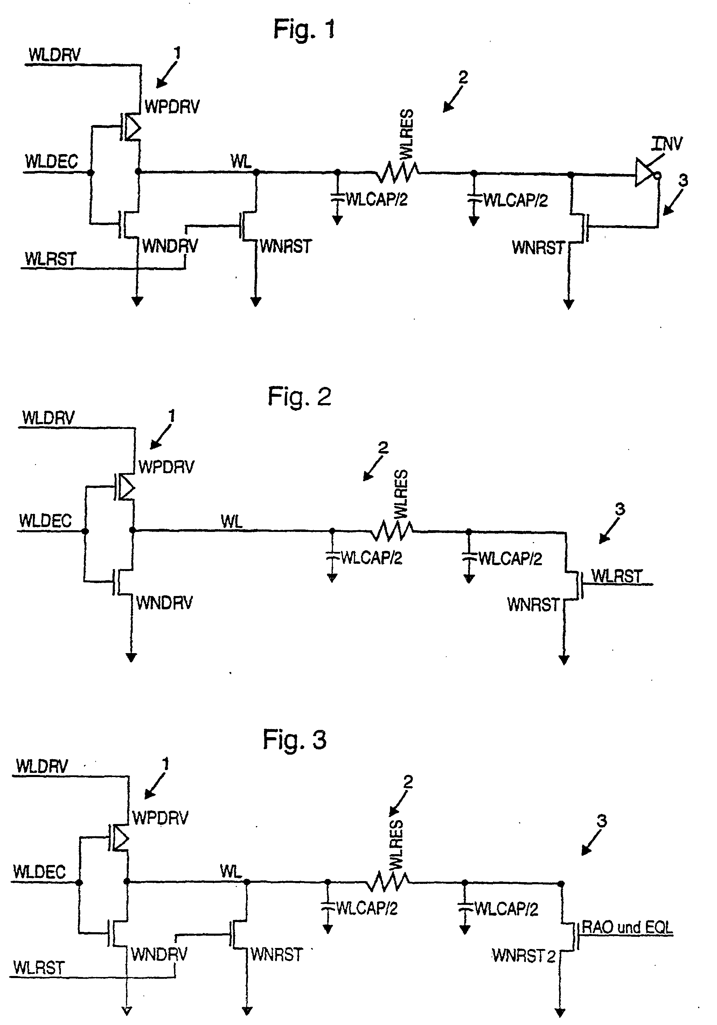

Fig. 1 zeigt eine Anordnung zur Übersprechdämpfung mit einem Decoder 1 aus einem P-Kanal-MOS-Transistor WPDRV und einem N-Kanal-MOS-Transistor WNDRV, einem Haltetransistor aus einem N-Kanal-MOS-Transistor WNRST und einer Wortleitung WL. Der Decoder 1 ist durch Signale WLDEC und WLDRV angesteuert, während an dem Haltetransistor WNRST ein Signal WLRST anliegt.

Die kapazitive Kopplung einer Anordnung 2 aus der Wortleitung WL zu (nicht gezeigten) benachbarten Wortleitungen ist durch Koppelkapazitäten WLCAP/2 angedeutet, während das ohmsche Verhalten der Wortleitung WL durch einen Widerstand WLRES veranschaulicht ist.

Im Standby-Betrieb sind die Signale WLRST und WLDEC beide auf einem hohen Zustand ("H"), während das Signal WLDRV auf Null-Potential ("0") ist. In diesem Fall ist die Wortleitung WL auf "0".

In einem ersten Hold- bzw. Halte-Betrieb (auch "Mix1"-Betrieb genannt) ist das Signal WLRST "0", während die Signale WLDEC und WLDRV beide "H" sind. In diesem Fall ist die Wortleitung WL "0". In einem zweiten Hold- bzw. Halte-Betrieb (auch "Mix2"-Betrieb genannt) ist das Signal WLRST "H", während die Signale WLDRV und WLDEC beide "0" sind. In diesem Fall befindet sich die Wortleitung WL auf "0".

In einem aktiven Betrieb der Anordnung 2 sind die Signale WLRST und WLDEC beide "0", während das Signal WLDRV auf "H" ist. In diesem Fall ist die Wortleitung WL auf "H".

Wie bereits eingangs erläutert wurde, beeinflußt eine lange Wortleitung WL, die auf "H" ist, durch kapazitive Kopplung benachbarte Wortleitungen, so daß ein "Übersprechen" auftritt. Dieses Übersprechen soll vermieden werden.

Es ist hierzu eine Pull-Down-Einrichtung 3 vorgesehen, die in der Anordnung von Fig. 1 aus einem Inverter INV an dem dem Decoder 1 gegenüberliegenden Ende der Wortleitung WL und einem N-Kanal-MOS-Transistor WNRST besteht, dessen Gateanschluß mit dem Ausgang des Inverters verbunden ist. Diese Pull-Down-Einrichtung 3, die keine zusätzlichen Signale benötigt, zieht das Potential der Wortleitung WL nach unten, wenn dieses durch Übersprechen von einer benachbarten Wortleitung, die sich im aktiven Zustand "H" befindet, auf ein vom Zustand "0" abweichendes Potential angehoben ist.

Fig. 2 zeigt eine weitere Anordnung zur Übersprechdämpfung, bei der der Haltetransistor WNRST an das von dem Decoder 1 abgewandte Ende der Wortleitung WL verlegt ist und hier als Pull-Down-Einrichtung 3 wirkt, die durch das Signal WLRST angesteuert ist. Diese Anordnung hat den Vorteil, daß keine zusätzlichen Transistoren bzw. Bauelemente erforderlich sind.

Fig. 3 zeigt ein Ausführungsbeispiel der Erfindung, bei dem zusätzlich zu dem als N-Kanal-MOS-Transistor ausgeführten Haltetransistor WNRST noch ein zweiter N-Kanal-MOS-Transistor WNRST2 an dem dem Decoder 1 entgegengesetzten Ende der Wortleitung WL als Pull-Down-Einrichtung 3 angeordnet ist. Dieser Transistor WNRST2 sorgt für eine besonders gute Übersprechdämpfung bei geringer Belastung der Wortleitung WL, da eine doppelseitige Dämpfung an den einer aktiven Wortleitung WL benachbarten Wortleitungen vorliegt. Auch sind keine zeitkritischen Signale erforderlich, die von außen an die Wortleitung gelegt werden müssen.

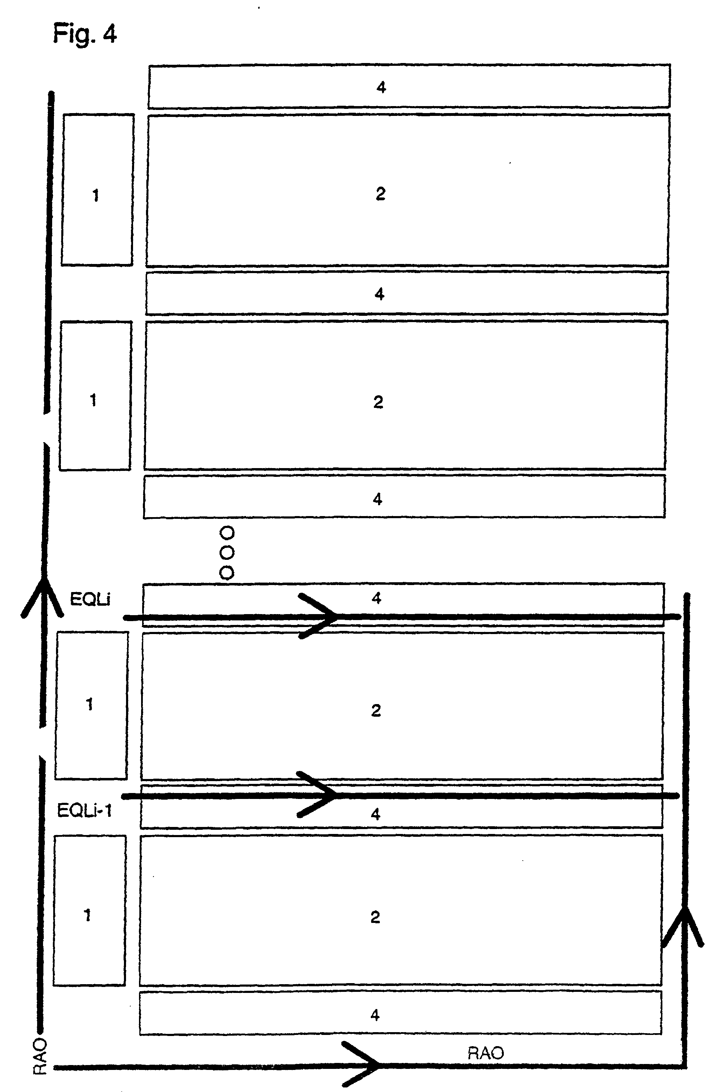

Das Ausführungsbeispiel der Fig. 3 erlaubt eine Segmentselektion unter Verwendung von Array-Steuersignalen RAO und EQLi, EQLi-1..., so daß beispielsweise in Abhängigkeit von dem Signal RAO jede zweite Wortleitung an ihrem dem Decoder 1 gegenüberliegenden Ende auf Masse gehalten ist, wie dies in Fig.4 für mehrere Anordnungen 2 zusammen mit Leseverstärkern 4 veranschaulicht ist.

## Patentansprüche

1. Anordnung zur Übersprechdämpfung in im wesentlichen parallel zueinander verlaufenden Wortleitungen (WL) von DRAM-Schaltungen (2), mit einem an einem ersten Ende der Wortleitung (WL) vorgesehenen Decoder (1) und einer an dem zum ersten Ende entgegengesetzten zweiten Ende der Wortleitung (WL) vorgesehenen Pull-Down-Einrichtung (3), die das Potential der Wortleitung (WL) im Standby- und Hold-Betrieb bei einer aktiven benachbarten Wortleitung (WL) herunterzieht und aus einem N-Kanal-MOS-Transistor (WNRST2) besteht, der durch ein Array-Steuersignal (RAO; EQL) ansteuerbar ist,
**dadurch gekennzeichnet,**
**daß** ein mit der Wortleitung (WL) verbundener Haltetransistor (WNRST) aus einem durch ein Signal (WLRST) angesteuerten N-Kanal-MOS-Transistor besteht, so daß eine doppelseitige Dämpfung an den zu einer aktiven Wortleitung (WL) benachbarten Wortleitungen möglich ist, und daß durch am Gate des N-Kanal-MOS-Transistors (WNRST2) der Pull-Down-Einrichtung (3) liegende Array-Steuersignale (RAO, EQL) eine Segmentselektion von Wortleitungen (WL) möglich ist.

## Claims

1. Configuration for the attenuation of crosstalk on wordlines (WL) which are oriented essentially parallel to each other in DRAM circuits (2), having a decoder (1) at a first end of the wordline (WL) and having a pull-down arrangement (3) at the second end, which is opposite to the first end, of the wordline (WL), which pull-down arrangement pulls down the potential of the wordline (WL) in standby mode and in hold mode if an adjacent wordline (WL) is active, said pull-down arrangement comprising an N-channel MOS transistor (WNRST2) which can be controlled by an array control signal (RAO, EQL),
**characterized in that** a holding transistor (WNRST) connected to the wordline (WL) comprises an N-channel MOS transistor which is controlled by a signal (WLRST), such that bilateral attenuation is possible on the wordlines adjacent to an active wordline (WL), and such that array control signals (RAO, EQL) on the gate of the N-channel MOS transistor (WNRST2) in the pull-down arrangement (3) allow segment selection of wordlines (WL).

## Revendications

1. Dispositif de réduction de la diaphonie dans des lignes (WL) de mot, s'étendant sensiblement parallèlement entre elles, de circuits de DRAM comprenant un décodeur (1) prévu sur une première extrémité de la ligne (WL) de mot et un dispositif (3) pull-down prévu sur la deuxième extrémité opposée à la première extrémité de la ligne (WL) de mot, qui abaisse le potentiel de la ligne (WL) de mot en fonctionnement de secours et de maintien, si une ligne (WL) de mot voisine y est mise, et qui est constitué d'un transistor (WNRST2) MOS à canal N qui peut être commandé par un signal (RAO ; EQL) de commande de réseau,
**caractérisé**
**en ce qu'**un transistor (WNRST) de maintien, relié à la ligne (WL) de mot, est constitué d'un transistor (MOS) à canal N commandé par un signal (WLRST) de manière à ce qu'une réduction de diaphonie de deux côtés soit possible sur les lignes de mot voisines d'une ligne (WL) de mot active, et de manière à ce que, par des signaux (RAO, EQL) de commande de réseau appliqués à la grille du transistor (WNRST2) MOS à canal N du dispositif (3) pull-down une segmentation de lignes (WL) de mot soit possible.
